# EUROPEAN PATENT SPECIFICATION

(11) **EP 2 302 682 B1**
(45) Date of publication and mention of the grant of the patent: **09.05.2012**
(21) Application number: 10250309.1
(22) Date of filing: 22.02.2010
(51) Int. Cl.: H01L 27/32, H01L 51/52

(54) **High contrast organic light emitting diode display**
Organische Leuchtdiodenanzeige hohen Kontrasts
Affichage à diodes électroluminescentes organiques à contraste élevée

(30) Priority: 13.08.2009 KR 20090074901
(43) Date of publication of application: 30.03.2011
(73) Proprietor: Samsung Mobile Display Co., Ltd., Yongin-city, Gyunggi-do 446-711 (KR)
(72) Inventor: Park, Soon-Ryong, Yongin-city, Gyunggi-do (KR); Jung, Woo-Suk, Yongin-city, Gyunggi-do (KR); Jeong, Hee-Seong, Yongin-city, Gyunggi-do (KR); Kim, Eun-Ah, Yongin-city, Gyunggi-do (KR); Kwak, Noh-Min, Yongin-city, Gyunggi-do (KR); Jeong, Chul-Woo, Yongin-city, Gyunggi-do (KR); Jeon, Hee-Chul, Yongin-city, Gyunggi-do (KR); Lee, Joo-Hwa, Yongin-city, Gyunggi-do (KR); Kim, Jae-Yong, Yongin-city, Gyunggi-do (KR)
(74) Representative: Mounteney, Simon James

(56) References cited:
- JP-A- 2003 058 070
- US-A1- 2003 098 856
- US-A1- 2003 127 656
- US-A1- 2005 035 353

## Description

### BACKGROUND OF THE INVENTION

### Field of the Invention

The present invention relates to an organic light emitting diode display with enhanced display characteristics.

### Description of the Related Art

An organic light emitting diode (OLED) display is a self emissive display device that displays images using organic light emitting diodes. The organic light emitting diode display differs from a liquid crystal display (LCD) in that it does not require a separate light source and has a relatively small thickness and weight. Furthermore, since the organic light emitting diode display has high quality characteristics such as low power consumption, high luminance, and short response time, the OLED display is spotlighted as a next generation display device for portable electronic appliances.

Usually, one or more electrodes of the organic light emitting diodes in the organic light emitting diode display, and other various metal wires thereof, reflect external light that is incident thereto from the outside. Accordingly, when the organic light emitting diode display is used in a bright area, the black color expression and the contrast thereof become poor due to the reflection of external light.

In order to solve such a problem, polarizing and phase retardation plates are provided on the organic light emitting diode so as to suppress the reflection of external light, however with the conventional method of suppressing the reflection of external light based on the polarizing and the phase retardation plates, it is problematic that much light generated by an organic emissive layer is eliminated when the external light is discharged to the outside through the polarizing and the phase retardation plates.
US 2003/127656 A1 and US 2005/035353 A1 each disclose an OLED display device with passive means for improving the contrast of the device by reducing reflection of ambient light, said passive means including a polarised light separating unit (e.g. a cholesteric liquid crystal layer) and a circular polariser formed of a quarter-wave plate and a linear polariser, the polarised light separating unit, the quarter-wave plate and the linear polariser being arranged in this order on the OLEDs of the display device.
US 2003/098856 A1 discloses an OLED display device having switchable contrast enhancing means arranged on its viewer side, wherein the switchable contrast enhancing means are formed by a quarter-wave plate and a switchable linear polariser constituting together a circular polariser, and wherein the switchable linear polariser is formed of nematic liquid crystal layer hosting a dichroic dye arranged between a pair of electrodes for driving the switchable linear polariser between a transparent non-polarising state and a transparent linear polarising state. Such an OLED display device is also disclosed in JP 2003 058070 A.

The above information disclosed in this Background of the Invention section is only for enhancement of understanding of the background of the invention and understanding of the background of the described technology and therefore it can contain information that does not constitute prior art.

### SUMMARY OF THE INVENTION

The present invention has been made in an effort to provide an organic light emitting diode display having advantages of suppressing reflection of external light to improve visibility while minimizing optical loss of light produced by the organic light emitting diodes that is transmitted to the outside.

An embodiment of the present invention provides an organic light emitting diode display including a substrate main body, an away of organic light emitting diodes each including a first electrode, an organic emissive layer, and a second electrode sequentially arranged on the substrate main body, a selective reflection layer arranged on the organic light emitting diodes, a phase retardation film arranged on the selective reflection layer, a first linear polarizing film arranged on the phase retardation film, a twisted nematic liquid crystal layer arranged on the first linear polarizing film, a liquid crystal driving electrode arranged on the twisted nematic liquid crystal layer and a second linear polarizing film arranged on the liquid crystal driving electrode.

When a respective one of the organic light emitting diodes is emitting light, an electric field is applied between the second electrode of said organic light emitting diode and the liquid crystal driving electrode, and when a respective one of the organic light emitting diodes is not emitting light, no electric field is applied between the second electrode of said organic light emitting diode and the liquid crystal driving electrode. When an electric field is applied between the second electrode of a respective one of the organic light emitting diodes and the liquid crystal driving electrode, liquid crystal molecules within the twisted nematic liquid crystal layer are vertically oriented in a direction crossing the liquid crystal driving electrode. External light linearly polarized by passing through the second linear polarizing film transparently can pass through the twisted nematic liquid crystal layer and the first linear polarizing film. Light produced by the respective organic light emitting diode and linearly polarized by passing through the first linear polarizing film can transparently pass through the twisted nematic liquid crystal layer and the second linear polarizing film.

When no electric field is applied between the second electrode of a respective one of the organic light emitting diodes and the liquid crystal driving electrode, liquid crystal molecules within the twisted nematic liquid crystal layer can be horizontally oriented while being twisted by 90 degrees. Among the horizontally oriented liquid crystal molecules, the liquid crystal molecules arranged closest to the liquid crystal driving electrode and the liquid crystal molecules arranged closest to the first linear polarizing film can be twisted by 90 degrees with respect to each other. Among the horizontally oriented liquid crystal molecules, the orientation direction of the liquid crystal molecules arranged closest to the liquid crystal driving electrode can coincide with the direction of the polarizing axis of the second linear polarizing film. Among the horizontally oriented liquid crystal molecules, the orientation direction of the liquid crystal molecules arranged closest to the first linear polarizing film can form a 90 degree angle with a direction of the polarizing axis of the first linear polarizing film. The direction of the axis of polarization of external light passing through the twisted nematic liquid crystal layer can cross a direction of the polarizing axis of the first linear polarizing film.

The direction of the polarizing axis of the first linear polarizing film can coincide with the direction of the polarizing axis of the second linear polarizing film. The selective reflection layer can be a cholesteric liquid crystal (CLC) layer. The selective reflection layer can pass one of the left-circular polarized light and the right-circular polarized light while reflecting the other. External light linearly polarized by passing through the first linear polarizing film can become circularly polarized upon passing through the phase retardation film. The circular polarized light passing through the phase retardation film can transparently pass through the selective reflection layer. The phase retardation film can be a 1/4 wavelength film, and the polarizing axis of the phase retardation film can form a 45 degree angle to the polarizing axis of the first linear polarizing film. Light produced by the respective organic light emitting diode and circularly polarized by passing through the selective reflection layer can become linearly polarized in a same direction as the direction of the polarizing axis of the first linear polarizing film upon passing through the phase retardation film. The organic light emitting diodes can emit light in a direction of the twisted nematic liquid crystal layer.

The above and other features of the invention are set out in the appended claims.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings in which like reference symbols indicate the same or similar components, wherein:

FIG. 1 is a cross-sectional view of an organic light emitting diode display according to an embodiment of the present invention;

FIG. 2 is a layout view of a driving circuit unit and an organic light emitting diode of the organic light emitting diode display shown in FIG. 1;

FIG. 3 is a cross-sectional view of the organic light emitting diode display taken along the III-III line of FIG. 2;

FIG. 4 is a schematic diagram illustrating the trajectory of external light flowing into the organic light emitting diode display shown in FIG. 1 when the organic light emitting diode is not emitting light;

FIG. 5 is a schematic diagram illustrating the trajectory of external light flowing into the organic light emitting diode display shown in FIG. 1 when the organic light emitting diode is not emitting light; and

FIG. 6 is a schematic diagram illustrating the trajectory of the light produced by the organic light emitting diode and propagating to the outside.

### DETAILED DESCRIPTION OF THE INVENTION

The present invention will be described more fully hereinafter with reference to the accompanying drawings, in which embodiments of the invention are shown. As those skilled in the art would realize, the described embodiments can be modified in various different ways, all without departing from the scope of the present invention.

Parts that are irrelevant to the description are omitted in order to clearly describe the present invention, and like reference numerals designate like elements throughout the specification.

Furthermore, the size and thickness of respective structural components shown in the drawings are arbitrarily illustrated for explanatory convenience, and the present invention is not necessarily limited to as illustrated.

In the drawings, the thickness of layers, films, panels, regions, etc., are exaggerated for clarity and explanatory convenience. It will be understood that when an element such as a layer, film, region, or substrate is referred to as being "on" another element, it can be directly on the other element or intervening elements can also be present.

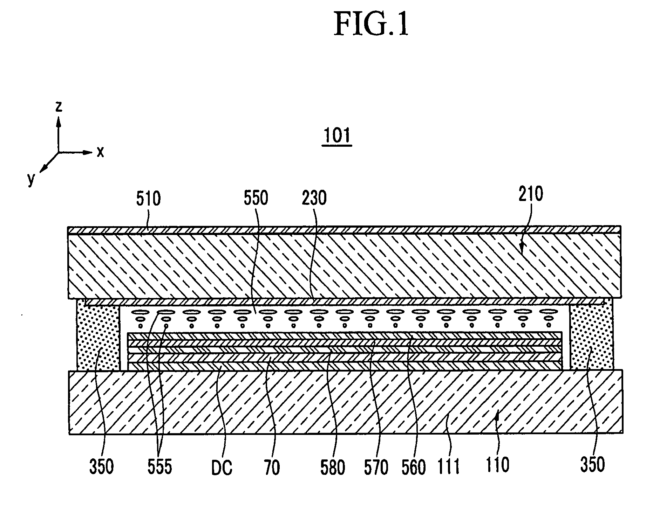

An embodiment of the present invention will be now described with reference to FIG. 1.

As shown in FIG. 1, an organic light emitting diode (OLED) display 101 according to an embodiment of the present invention includes a display substrate 110 with an organic light emitting diode 70, which is sequentially overlaid with a selective reflection layer 580, a phase retardation film 570, a first linear polarizing film 560, a twisted nematic (TN) liquid crystal layer 550, a liquid crystal driving electrode 230, and a second linear polarizing film 510.

Furthermore, the organic light emitting diode display 101 includes an encapsulation substrate 210 disposed on the twisted nematic liquid crystal layer 550 and sealed to the display substrate 110. That is, the organic light emitting diode 70, the selective reflection layer 580, the phase retardation film 570, the first linear polarizing film 560, and the twisted nematic liquid crystal layer 550 are arranged within the sealed space between the display substrate 110 and the encapsulation substrate 210. The liquid crystal driving electrode 230 and the second linear polarizing film 510 can be arranged within the sealed space between the display substrate 110 and the encapsulation substrate 210, or external to the encapsulation substrate 210. It is illustrated in FIG. 1 that only the second linear polarizing film 510 is arranged outside of the sealed space, that is, external to the encapsulation plate 210, but an the present invention is not limited thereto.

The organic light emitting diode display 101 further includes a sealant 350, which is disposed between the display substrate 110 and the encapsulation substrate 210 along the edges thereof so as to seal the display substrate 110 and the encapsulation substrate 210 to each other.

The display substrate 110 includes a substrate main body 111 and a driving circuit DC, in addition to the organic light emitting diode 70.

The substrate main body 111 can be made out of an insulating material such as glass, quartz, ceramic or plastic, however, the present invention is not limited thereto as the substrate main body 111 can instead be made out of a metallic material such as stainless steel.

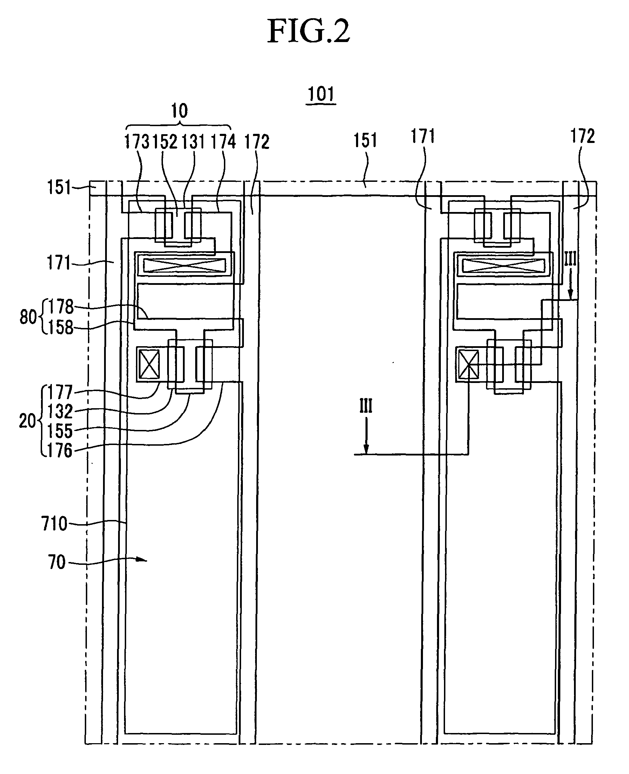

The driving circuit DC is formed on the substrate main body 111. As shown in FIG. 2, the driving circuit DC includes thin film transistors 10 and 20 to drive the organic light emitting diode 70. Specifically, the organic light emitting diode 70 emits light upon receipt of driving signals from the driving circuit DC so as to display images.

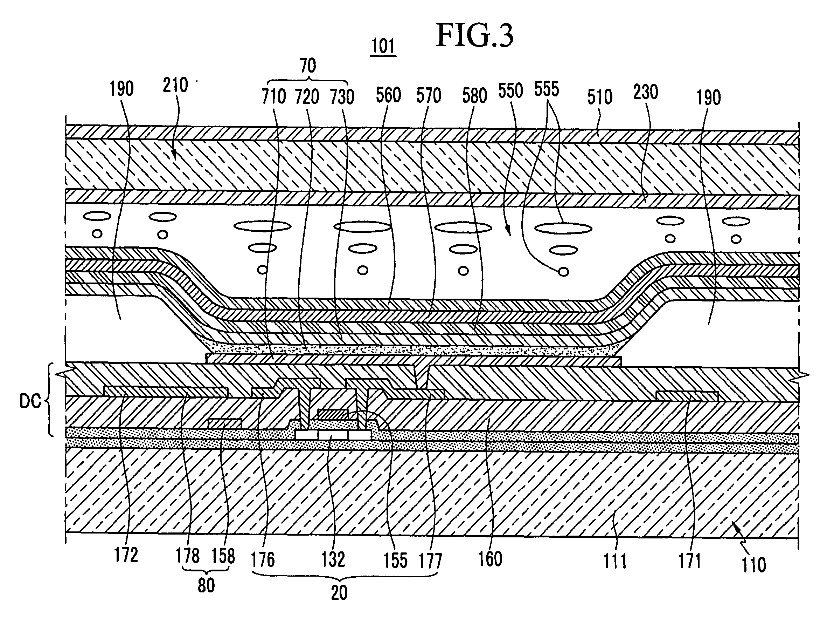

The specific structure of the driving circuit DC and the organic light emitting diode 70 is illustrated in FIGS. 2 and 3, but the present invention is not limited to the structure shown in FIG. 2 and FIG. 3. The driving circuit DC and the organic light emitting diode 70 can be variously structured to the extent that such a structure can be easily embodied by a person of ordinary skill in the art.

Meanwhile, the organic light emitting diode 70 emits light in the direction of the twisted nematic liquid crystal layer 550. That is, in this embodiment of the present invention, the organic light emitting diode display 101 is structured as a front emission type.

The display substrate 110 further includes a pixel definition layer 190. The pixel definition layer 190 has an opening exposing a first electrode 710 of the organic light emitting diode 70.

The selective reflection layer 580 is arranged on the organic light emitting diode 70. The selective reflection layer 580 is formed as a cholesteric liquid crystal (CLC) layer. The selective reflection layer will be referred to hereinafter as a cholesteric liquid crystal layer 580.

The cholesteric liquid crystal has a layered structure as a smectic liquid crystal, but the directors thereof are similar in molecular plane orientation to a nematic liquid crystal. Specifically, the cholesteric liquid crystal has a structure where the molecules thereof are helically oriented. That is, with the cholesteric liquid crystal, thin and long molecules are oriented parallel to each other within a plane in the director axis direction, and the molecular axes are slightly deviated in orientation proceeding perpendicular to the plane. Accordingly, the cholesteric liquid crystal wholly has a helical structure. The cholesteric liquid crystal has characteristics such as optical rotation power, selective optical dispersion, circular polarization, and dichroism.

Therefore, the cholesteric liquid crystal layer 580 can selectively transmit or reflect circular polarized optical components. That is, the cholesteric liquid crystal layer 580 passes either one of the left-circular polarized light and the right-circular polarized light, and reflects the other. In this embodiment of the present invention, the cholesteric liquid crystal layer 580 is formed such that it transmits right-circular polarized light while reflecting left-circular polarized light, however the present invention is not limited thereto.

The phase retardation film 570 is arranged on the cholesteric liquid crystal layer 580. A 1/4 wavelength plate is used as the phase retardation film 570. The phase retardation film 570 has an optical axis that is twisted from the polarizing axis of the first linear polarizing film 560 to be described later, by about 45 degrees. That is, the angle in direction of the optical axis of the phase retardation film 570 to the polarizing axis of the first linear polarizing film 560 is about 45 degrees.

Accordingly, the linearly polarized light passing through the first linear polarizing film 560 is circular polarized while passing through the phase retardation film 570. As the angle in direction between the optical axis of the phase retardation film 570 and the polarizing axis of the first linear polarizing film 560 approximates 45 degrees, the linearly polarized light passing through the first linear polarizing film 560 approximates circular polarization while passing the phase retardation film 570.

Furthermore, the circular polarized light passing through the phase retardation film 570 transparently passes the cholesteric liquid crystal layer 580. Specifically, in this embodiment of the present invention, the linearly polarized light passing through the first linear polarizing film 560 is right-circular polarized while passing the phase retardation film 570, and the right-circular polarized light transparently passes the cholesteric liquid crystal layer 580.

Conversely, when the circular polarized light passing through the cholesteric liquid crystal layer 580 is linearly polarized while passing through the phase retardation film 570, it can directly pass through the first linear polarizing film 560.

Furthermore, various kinds of phase retardation films that are well known to a person of ordinary skill in the art can be used as the phase retardation film 570.

The first linear polarizing film 560 is arranged on the phase retardation film 570. The first linear polarizing film 560 has a predetermined polarizing axis. The first linear polarizing film 560 passes the light coinciding in direction with the polarizing axis, and absorbs the light not coinciding in direction with the polarizing axis. That is, the light passing through the first linear polarizing film 560 is linearly polarized in the same direction as the direction of the polarizing axis of the first linear polarizing film 560.

The polarizing axis of the first linear polarizing film 560 is oriented in the same direction as the linear polarizing direction of the light that is circular polarized while passing through the cholesteric liquid crystal layer 580 and linearly polarized while passing through the phase retardation film 570. Accordingly, the light passing through the cholesteric liquid crystal layer 580 can directly pass through the first linear polarizing film 560 via the phase retardation film 570 without incurring any substantial loss.

Furthermore, the polarizing axis of the first linear polarizing film 560 and the polarizing axis of the second linear polarizing film 510 are oriented such that they coincide in direction with each other.

Various kinds of polarizing films that are well known to a person of ordinary skill in the art can be used as the first linear polarizing film 560 and the second linear polarizing film 510.

The twisted nematic liquid crystal layer 550 is arranged on the first linear polarizing film 560. The twisted nematic liquid crystal layer 550 contains TN-type liquid crystal molecules 555. Various liquid crystal molecules that are well known to a person of ordinary skill in the art can be used as the TN-typed liquid crystal molecules 555.

The twisted nematic liquid crystal layer 550 is disposed between a second electrode 730 of the organic light emitting diode 70 shown in FIG. 3 and the liquid crystal driving electrode 230 to be described later.

When an electric field is applied between the second electrode 730 of the organic light emitting diode 70 and the liquid crystal driving electrode 230, the liquid crystal molecules 555 arranged within the twisted nematic liquid crystal layer 550 are perpendicularly oriented in a direction crossing the liquid crystal driving electrode 230 (in the z-axis direction).

Accordingly, when an electric field is applied between the second electrode 730 of the organic light emitting diode 70 and the liquid crystal driving electrode 230, the light that is linearly polarized in the direction of the polarizing axis of the first linear polarizing film 560 and the second linear polarizing film 510 freely passes through the space between the first linear polarizing film 560 and the second linear polarizing film 510. That is, when an electric field is applied between the second electrode 730 of the organic light emitting diode 70 and the liquid crystal driving electrode 230, the linearly polarized light passing through the first linear polarizing film 560 can directly pass through the twisted nematic liquid crystal layer 550 and the second linear polarizing film 510. Furthermore, the linearly polarized light passing through the second linear polarizing film 510 can directly pass through the twisted nematic liquid crystal layer 550 and the first linear polarizing film 560.

On the contrary, when no electric field is applied between the second electrode 730 of the organic light emitting diode 70 and the liquid crystal driving electrode 230, the liquid crystal molecules 555 arranged within the twisted nematic liquid crystal layer 550 are horizontally oriented parallel to the liquid crystal driving electrode 230 (in the x-axis direction or in the y-axis direction). At this time, with the horizontally oriented liquid crystal molecules 555, the orientation direction of the liquid crystal molecules 555 positioned relatively close to the liquid crystal driving electrode 230 (the x-axis direction) and the orientation direction of the liquid crystal molecules 555 positioned relatively close to the first linear polarizing film 560 (the y-axis direction) are twisted to cross each other, with a twist angle of about 90 degrees. That is, the liquid crystal molecules 555 positioned close to the liquid crystal driving electrode 230 and the liquid crystal molecules 555 positioned close to the first linear polarizing film 560 are oriented while being twisted by 90 degrees with respect to each other.

Specifically, when no electric field is applied between the second electrode 730 of the organic light emitting diode 70 and the liquid crystal driving electrode 230, the liquid crystal molecules 555 of the twisted nematic liquid crystal layer 550 positioned close to the liquid crystal driving electrode 230 are oriented in a direction coinciding with the direction of the polarizing axis of the second linear polarizing film 510 (in the x-axis direction). The liquid crystal molecules 550 of the twisted nematic liquid crystal layer 550 positioned close to the first linear polarizing film 560 are oriented in a direction that is angled in the direction of the polarizing axis of the first linear polarizing film 560 by 90 degrees (in the y-axis direction). The x-axis direction and the y-axis direction are substantially perpendicular to each other.

That is, when no electric field is applied between the second electrode 730 of the organic light emitting diode 70 and the liquid crystal driving electrode 230, the linearly polarized light passing through the second linear polarizing film 510 is rotated in phase by 90 degrees while passing through the twisted nematic liquid crystal layer 550. As the direction of the polarizing axis of the first linear polarizing film 510 (the x-axis direction) is the same as the direction of the polarizing axis of the second linear polarizing film 560 (the x-axis direction), the linearly polarized light that is altered in phase while passing through the twisted nematic liquid crystal layer 550 does not pass through the first linear polarizing film 560 and is thus eliminated.

Meanwhile, when the organic light emitting diode 70 emits light, an electric field is applied between the second electrode 730 of the organic light emitting diode 70 and the liquid crystal driving electrode 230, whereas when the organic light emitting diode 70 does not emit light, no electric field is applied therebetween.

FIG. 1 illustrates the case where no electric field is applied between the second electrode 730 of the organic light emitting diode 70 and the liquid crystal driving electrode 230.

The liquid crystal driving electrode 230 is formed on the twisted nematic liquid crystal layer 550. The liquid crystal driving electrode 230 includes a transparent conductive layer. The transparent conductive layer is made out of indium tin oxide (ITO), indium zinc oxide (IZO), zinc oxide (ZnO), or indium oxide (In₂O₃). As described above, the liquid crystal driving electrode 230 applies an electric field to the twisted nematic liquid crystal layer 550 in association with the second electrode 730 of the organic light emitting diode 70.

The encapsulation substrate 210 is formed on the liquid crystal driving electrode 230. The encapsulation substrate 210 is made out of a transparent insulating material such as glass, quartz, ceramic or plastic. The liquid crystal driving electrode 230 is formed on a surface of the encapsulation substrate 210 via deposition.

The second linear polarizing film 510 is arranged on the encapsulation substrate 210. The second linear polarizing film 510 is formed in the same way as the first linear polarizing film 560. In an alternative embodiment the second linear polarizing film 510 can be disposed between the liquid crystal driving electrode 230 and the encapsulation substrate 210.

With the above structure, the organic light emitting diode display 101 suppresses reflection of external light so as to enhance visibility and minimize the amount of optical loss from the organic light emitting diode 70 to the outside.

The internal structure of the organic light emitting diode display 101 will be described in detail while concentrating on the driving circuit DC and the organic light emitting diode 70, with reference to FIG. 2 and FIG. 3. The pixel is a minimal unit for displaying image, and is provided at the respective pixel areas. The organic light emitting diode display 101 displays images through a plurality of pixels. FIG. 2 is a layout view of a pixel structure of the display substrate 110, and FIG. 3 is a cross-sectional view of the display substrate 110 and the encapsulation substrate 210 taken along the III-III line of FIG. 2.

FIGS. 2 and 3 illustrate the active matrix (AM) organic light emitting diode display 101 with a 2Tr-1Cap structure where two thin film transistors (TFT) 10 and 20 and a capacitor 80 are included in each pixel, but the present invention is not limited thereto. Accordingly, the organic light emitting diode display 101 can have three or more thin film transistors and two or more capacitors per each pixel, and a separate wire with various different structures.

As shown in FIG. 2 and FIG. 3, the display substrate 110 includes a switching thin film transistor 10, a driving thin film transistor 20, a capacitor 80, and an organic light emitting diode 70, which are formed at each pixel. The structure constructed by the switching thin film transistor 10, the driving thin film transistor 20, and the capacitor 80 is called a driving circuit DC. The display substrate 110 further includes gate lines 151 arranged in a direction, data lines 171 crossing the gate lines 151 in an insulated manner, and a common power line 172.

A pixel can be defined by taking the gate lines 151, the data lines 171, and the common power line 172 as a boundary, but is not limited thereto.

The organic light emitting diode 70 includes a first electrode 710 as an anode, a second electrode 730 as a cathode, and an organic emissive layer 720 disposed between the first and second electrodes 710 and 730, however the present invention is not limited thereto. That is, the first electrode 710 can instead function as the cathode and the second electrode 730 can instead function as the anode.

Furthermore, as the organic light emitting diode display 101 has a front side emission structure, the first electrode 710 is made out of a reflective layer and the second electrode 730 is made out of a semi-transparent layer. Accordingly, the light generated in the organic emissive layer 720 is discharged through the second electrode 730.

The reflective layer and the semitransparent layer are made out of one or more metallic materials selected from magnesium (Mg), silver (Ag), gold (Au), calcium (Ca), lithium (Li), chromium (Cr), and aluminum (Al), or alloys thereof. The reflective layer and the semitransparent layer are determined depending upon the thickness thereof. The semitransparent layer commonly has a thickness of 200nm or less. When the thickness of the semitransparent layer becomes smaller, the light transmission thereof is increased, whereas when the thickness of the semitransparent layer becomes larger, the light transmission thereof is decreased.

Furthermore, the first electrode 710 can contain a transparent conductive layer. That is, the first electrode 710 can have a multi-layered structure with a reflective layer and a transparent conductive layer. The transparent conductive layer can be made out of indium tin oxide (ITO), indium zinc oxide (IZO), zinc oxide (ZnO), or indium oxide In₂O₃. The transparent conductive layer has a relatively high work function, and is disposed between the reflective layer and the organic emissive layer 720.

The organic emissive layer 720 has a multi-layered structure having an emissive layer, a hole injection layer (HIL), a hole transporting layer (HTL), an electron transporting layer (ETL), and an electron injection layer (EIL). When the organic emissive layer 720 has all the above components, the hole injection layer (HIL) is disposed on the first electrode 710 being the anode, and the hole transporting layer (HTL), the emissive layer, the electron transporting layer (ETL), the electron injection layer (EIL) are sequentially deposited thereon. Furthermore, when needed, the organic emissive layer 720 can include additional layers not mentioned above and still be within the scope of the present invention.

With the above structure, the organic light emitting diode 70 injects holes and electrons into the organic emissive layer 720 through the first and second electrodes 710 and 730. When excitons, being combinations of the injected holes and electrons, fall from an excited state to a ground state, the organic light emitting diode 70 emits light.

The capacitor 80 includes a pair of capacitor plates 158 and 178 with an interlayer insulating layer 160 therebetween. Here, the interlayer insulating layer 160 functions as a dielectric. The capacitance is determined depending upon charges charged at the capacitor 80 and the voltages applied to the capacitor plates 158 and 178.

The switching thin film transistor 10 includes a switching semiconductor layer 131, a switching gate electrode 152, a switching source electrode 173, and a switching drain electrode 174. The driving thin film transistor 20 includes a driving semiconductor layer 132, a driving gate electrode 155, a driving source electrode 176, and a driving drain electrode 177.

The switching thin film transistor 10 is used as a switch for selecting pixels to emit light. The switching gate electrode 152 is connected to the gate line 151, the switching source electrode 173 is connected to the data line 171, the switching drain electrode 174 is spaced apart from the switching source electrode 173 by a distance and is connected to the capacitor plate 158.

The driving thin film transistor 20 applies the driving power for exciting the organic emissive layer 720 of the organic light emitting diode 70 within the selected pixel to the pixel electrode 710. The driving gate electrode 155 is connected to the capacitor plate 158 that is connected to the switching drain electrode 174. The driving source electrode 176 and the other capacitor plate 178 are connected to the common power line 172, respectively. The driving drain electrode 177 is connected to the pixel electrode 170 of the organic light emitting diode 70 through a contact hole.

With the above structure, the switching thin film transistor 10 is driven by the gate voltage applied to the gate line 151 so as to transmit the data voltage applied to the data line 171 to the driving thin film transistor 20. The voltage, being the difference between the common voltage applied from the common power line 172 to the driving thin film transistor 20 and the data voltage transmitted thereto from the switching thin film transistor 10, is stored in capacitor 80, and the current corresponding to the voltage stored in capacitor 80 flows to the organic light emitting diode 70 through the driving thin film transistor 20 so that the organic light emitting diode 70 emits light.

The light generated in the organic light emitting diode 70 is discharged to the outside while sequentially passing through the cholesteric liquid crystal layer 580, the phase retardation film 570, the first linear polarizing film 560, the twisted nematic liquid crystal layer 550, the liquid crystal driving electrode 230, the encapsulation substrate 210, and the second linear polarizing film 510. In this process, with the organic light emitting diode display 101 according to this embodiment of the present invention, little light generated from the organic light emitting diode is dissipated.

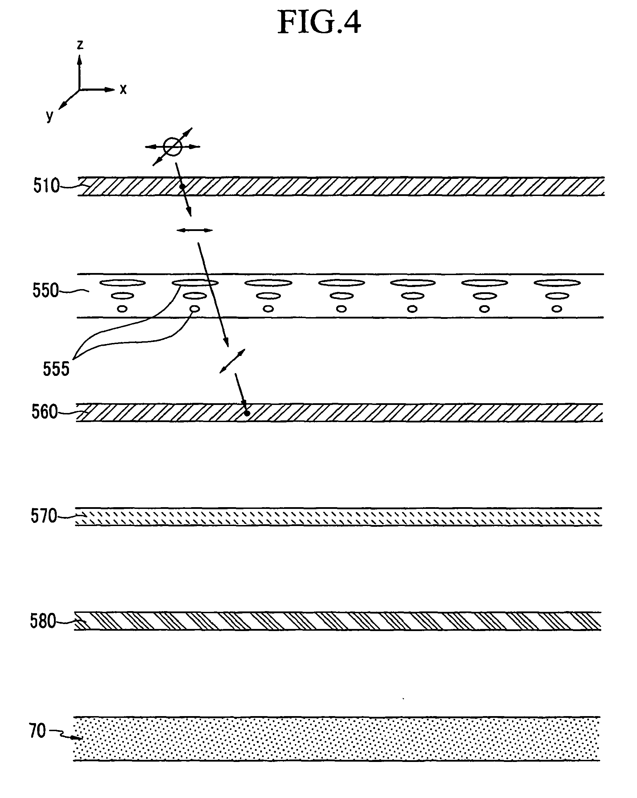

The operation principle where the organic light emitting diode display 101 suppresses the reflection of external light when the organic light emitting diode 70 does not emit light will now be specifically described with reference to FIG. 4.

When the organic light emitting diode 70 is not emitting light, as shown in FIG. 4, no electric field is applied between the second electrode 730 of the organic light emitting diode 70 and the liquid crystal driving electrode 230 of FIG. 3. Accordingly, the liquid crystal molecules 555 of the twisted nematic liquid crystal layer 550 are oriented in the horizontal direction (in the x-axis direction or in the y-axis direction) while being twisted by 90 degrees. At this time, the liquid crystal molecules 550 positioned closest to the liquid crystal driving electrode 230 are oriented in the direction of the polarizing axis of the second linear polarizing film 510 (in the x-axis direction). The liquid crystal molecules 555 positioned closest to the first linear polarizing film 560 are oriented in a direction (in the y-axis direction) crossing the direction of the polarizing axis of the second linear polarizing film 560 (the x-axis direction).

The external light is dissipated by about 50% while passing through the second linear polarizing film 510. The second linear polarizing film 510 passes only the optical components polarized in the same direction as the direction of the polarizing axis of the second linear polarizing film 510 (the x-axis direction), and absorbs all the other optical components.

The linearly polarized external light passing through the second linear polarizing film 510 is altered in phase by 90 degrees while passing through the twisted nematic liquid crystal layer 550. That is, the light that is linearly polarized in the x-axis direction while passing through the second linear polarizing film 510 is linearly polarized in the y-axis direction while passing through the twisted nematic liquid crystal layer 550. And the light that is linearly polarized in the y-axis direction while passing through the twisted nematic liquid crystal layer 550 does not pass through the first linear polarizing film 560, and is thus eliminated completely. This is because the polarizing axis of the first linear polarizing film 560 is directed in the x-axis direction as with the second polarizing film 510.

In this way, when the organic light emitting diode 70 does not emit light, the reflection of external light is essentially entirely suppressed. Accordingly, the organic light emitting diode display 101 can enhance the expression of a black color and contrast.

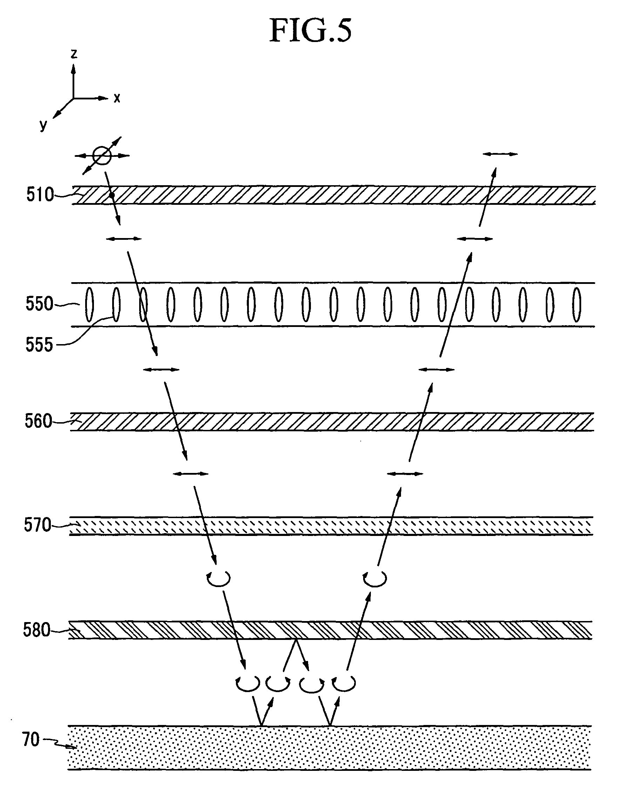

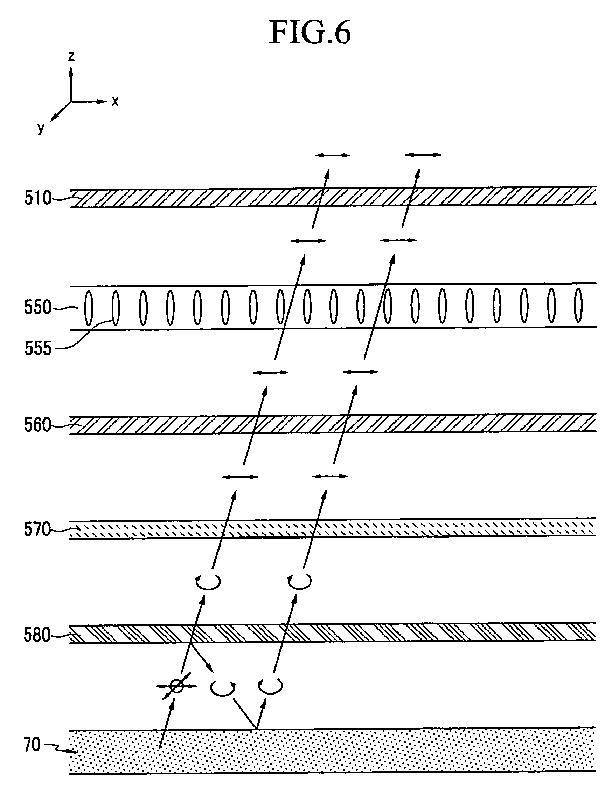

The operation principle of the organic light emitting diode display 101 in that the light generated from the organic light emitting diode 70 is effectively discharged to the outside while suppressing the reflection of external light when the organic light emitting diode 70 emits light will be specifically described with reference to FIGS. 5 and 6.

When the organic light emitting diode 70 emits light, as shown in FIGS. 5 and 6, an electric field is applied between the second electrode 730 of the organic light emitting diode 70 shown in FIG. 3 and the liquid crystal driving electrode 230 shown in FIG. 3. Accordingly, the liquid crystal molecules 555 of the twisted nematic liquid crystal layer 550 are all oriented in the vertical direction (in the y-axis direction).

The trajectory of external light flowing into the organic light emitting diode display 101 from the outside will be first described with reference to FIG. 5.

The external light is dissipated by about 50% while passing through the second linear polarizing film 510. And the linearly polarized light passing through the second linear polarizing film 510 transparently passes through the twisted nematic liquid crystal layer 550 where the liquid crystal molecules 555 are vertically oriented and the first linear polarizing film 560 having the same polarizing axis as the second linear polarizing film 510.

The linearly polarized light passing through the first linear polarizing film 560 becomes circular polarized upon passing through the phase retardation film 570 being the 1/4 wavelength plate. At this time, the circular polarization is a right-circular polarization, however, the present invention is not limited thereto. Accordingly, the phase retardation film 570 can instead be disposed such that the light passing through the phase retardation film 570 is left-circular polarized, but in this case, the cholesteric liquid crystal layer 580 should be able to pass the left-circular polarized light.

The right-circular polarized light passing through the phase retardation film 570 transparently passes through the cholesteric liquid crystal layer 580. In this embodiment of the present invention, the cholesteric liquid crystal layer 580 passes the right-circular polarized light and reflects the left-circular polarized light, however the present invention is not limited thereto. Therefore, the cholesteric liquid crystal layer 580 can instead pass the left-circular polarized light and reflect the right-circular polarized light, but in this case, the light passing through the phase retardation film 570 should be a left-circular polarized light. That is, the cholesteric liquid crystal layer 580 should necessarily pass the circular polarized light after the light sequentially passes the first linear polarizing film 560 and the phase retardation film 570.

The right-circular polarized light passing through the cholesteric liquid crystal layer 580 is reflected by the first electrode 710 of the organic light emitting diode 70 shown in FIG. 3 or the second electrode 730 thereof shown in FIG. 3. Furthermore, the right-circular polarized light passing through the cholesteric liquid crystal layer 580 can be reflected against other metal wires, in addition to the organic light emitting diode 70.

When the right-circular polarized light is reflected against the organic light emitting diode 70, it is altered in phase into a left-circular polarization by 180 degrees. The reflected and left-circular polarized light is reflected against the cholesteric liquid crystal layer 580 while not passing through it, and is directed back toward the organic light emitting diode 70.

The left-circular polarized light is again reflected off the organic light emitting diode 70, and is altered in phase into a right-circular polarization. The right-circular polarized light sequentially passes through the cholesteric liquid crystal layer 580 and the phase retardation film 570 so that it is linearly polarized. The linearly polarized light has the same direction as the direction of the polarizing axis of the first linear polarizing film 560. Accordingly, the linearly polarized light passing through the phase retardation film 570 transparently passes through the first linear polarizing film 560, the twisted nematic liquid crystal layer 550, and the second linear polarizing film 510 so that it is discharged to the outside.

In this way, when the organic light emitting element 70 emits light, the reflection of external light can be suppressed by about 50%.

Now, the trajectory of the light generated in the organic light emitting diode 70 and discharged to the outside will be described with reference to FIG. 6.

The light generated from the organic light emitting diode 70 first passes through the cholesteric liquid crystal layer 580. Meanwhile, various phases are entangled in the light generated by the organic light emitting diode 70. With the light generated from the organic light emitting diode 70, the right-circular polarized optical components freely pass through the cholesteric liquid crystal layer 580 and progress toward the phase retardation film 570, while the left-circular polarized optical components are reflected against the cholesteric liquid crystal layer 580 and are directed toward the organic light emitting diode 70, followed by being reflected against the organic light emitting diode 70. With the light reflected against the organic light emitting diode 70, the right-circular polarized optical components freely pass through the cholesteric liquid crystal layer 580, and progress toward the phase retardation film 570. With the above process repeated, the light generated from the organic light emitting diode 70 almost entirely passes through the cholesteric liquid crystal layer 580 and progresses toward the phase retardation film 570.

The right-circular polarized light passing through the cholesteric liquid crystal layer 580 is linearly polarized while passing through the phase retardation film 570. The linearly polarized light passing through the phase retardation film 570 sequentially passes through the first linear polarizing film 560, the twisted nematic liquid crystal layer 550, and the second linear polarizing film 510, and is discharged to the outside where it can be viewed.

In this way, nearly all the light generated by the organic light emitting diode 70 is discharged to the outside without incurring any substantial loss.

As described above, with an organic light emitting diode display 101 according to the present invention, when the organic light emitting diode 70 is not emitting light, the reflection of external light is mostly suppressed.

Furthermore, with the organic light emitting diode display 101, when the organic light emitting diode 70 is emitting light, the reflection of external light is suppressed by about 50%, and the light generated from the organic light emitting diode 70 is mostly discharged to the outside without incurring any substantial loss.

In sum, the organic light emitting diode display 101 suppresses the reflection of external light so as to enhance visibility, and minimizes the amount of optical loss from the organic light emitting diode 70 to the outside.

While this invention has been described in connection with what is presently considered to be practical embodiments, it is to be understood that the invention is not limited to the disclosed embodiments, but, on the contrary, is intended to cover various modifications included within the scope of the appended claims.

## Claims

1. An organic light emitting diode display (101), comprising:
a substrate main body (111);
an array of organic light emitting diodes (70) each including a first electrode (710), an organic light emissive layer (720), and a second electrode (730) sequentially arranged on the substrate main body (111);
a selective reflection layer (580) arranged on the organic light emitting diodes (70);
a phase retardation film (570) arranged on the selective reflection layer (580);
a first linear polarizing film (570) arranged on the phase retardation film (570);
**characterised by**
a twisted nematic liquid crystal layer (550) arranged on the first linear polarizing film (560);
a liquid crystal driving electrode (230) arranged on the twisted nematic liquid crystal layer (550); and
a second linear polarizing film (510) arranged on the liquid crystal driving electrode (230).

2. An organic light emitting diode display (101) according to claim 1 wherein the display is adapted to apply an electric field between the second electrode (730) of any one of the organic light emitting diodes (70) and the liquid crystal driving electrode (230) when the respective organic light emitting diode (70) is emitting light, and not apply an electric field between the second electrode (730) of any one of the organic light emitting diode (70) and the liquid crystal driving electrode (230) when the respective organic light emitting diode (70) is not emitting light.

3. An organic light emitting diode display (101) according to claim 2, wherein, when an electric field is applied between the second electrode (730) of a respective one of the organic light emitting diodes (70) and the liquid crystal driving electrode (230), liquid crystal molecules (555) whithin the twisted nematic liquid crystal layer (550) are substantially oriented in a direction extending between the front and rear of the display (101).

4. An organic light emitting diode display (101) according to claim 3, wherein the twisted nematic liquid crystal layer (550) and the first linear polarizing film (560), are adapted to transparently pass external light that has been linearly polarized by passing through the second linear polarizing film (510).

5. An organic light emitting diode display (101) according to claim 3 or 4, wherein the twisted nematic liquid crystal layer (550) and the second linear polarizing film (510), are adapted to transparently pass light produced by a respective organic light emitting diode (70) and linearly polarized by passing through the first linear polarizing film (560).

6. An organic light emitting diode display (101) according to any of claims 2 to 5, wherein, when no electric field is applied between the second electrode (730) of a respective one of the organic light emitting diodes (70) and the liquid crystal driving electrode (230), liquid crystal molecules (555) within the twisted nematic liquid crystal layer (550) are substantially oriented in a direction extending across the display (101) while being twisted by 90 degrees.

7. An organic light emitting diode display (101) according to claim 6, wherein, when no electric field is applied between the second electrode (730) of a respective one of the organic light emitting diodes (70) and the liquid crystal driving electrode (230), liquid crystal molecules (555) arranged closest to the liquid crystal driving electrode (230) and liquid crystal molecules (555) arranged closest to the first linear polarizing film (560) are twisted by 90 degrees with respect to each other.

8. An organic light emitting diode display (101) according to claim 7, wherein, when no electric field is applied between the second electrode (730) of a respective one of the organic light emitting diodes (70) and the liquid crystal driving electrode (230), the orientation direction of the liquid crystal molecutes (555) arranged closest to the liquid crystal driving electrode (230) coincides with the direction of the polarizing axis of the second linear polarizing film (510).

9. An organic light emitting diode display (101) according to claim 7 or 8, wherein, when no electric field is applied between the second electrode (730) of a respective one of the organic light emitting diodes (70) and the liquid crystal driving electrode (230), the orientation direction of the liquid crystal molecules (555) arranged closest to the first linear polarizing film (560) form a 90 degree angle with a direction of the polarizing axis of the first linear polarizing film (560).

10. An organic light emitting diode display (101) according to claim 7, 8 or 9 wherein when no electric field is applied between the first electrode (710) of a respective one of the organic light emitting diodes (70) and the liquid crystal driving electrode first, the direction of the axis of polarization of external light passing through the twisted (230) nematic liquid crystal layer (550) crosses a direction of the polarizing axis of the first linear polarizing film (560).

11. An organic light emitting diode display (101) according to any preceding claim, wherein the direction of the polarizing axis of the first linear polarizing film (560) coincides with the direction of the polarizing axis of the second linear polarizing film (510).

12. An organic light emitting diode display (101) according to any preceding claim, wherein the selective reflection layer (580) is a cholesteric liquid crystal, CLC, layer.

13. An organic light emitting diode display (101) according to claim 12, wherein the selective reflection layer (580) is adapted to pass one of left-circular polarized light and right-circular polarized light while reflecting the other.

14. An organic light emitting diode display (101) according to any preceding claim, wherein the phase retardation film (570) is adapted to circularly polarize external light that has been linearly polarized by passing through the first linear polarizing film (560).

15. An organic light emitting diode display (101) according to any preceding claim, wherein the selective reflection layer (580) is adapted to transparently pass circular polarized light that has passed through the phase retardation film (570).

16. An organic light emitting diode display (101) according to any preceding claim, wherein the phase retardation film (570) is a 1/4 wavelength film, and the polarizing axis of the phase retardation film (570) forms a 45 degree angle to the polarizing axis of the first linear polarizing film (560).

17. An organic light emitting diode display (101) according to any preceding claim, adapted to cause light produced by the organic light emitting diode (70) and circularly polarized by passing through the selective reflection layer (580) to become linearly polarized in a same direction as the direction of the polarizing axis of the first linear polarizing film (560) upon passing through the phase retardation film (570).

18. An organic light emitting diode display (101) according to any preceding claim, wherein the organic light emitting diodes (70) emit light in a direction of the twisted nematic liquid crystal layer (550).

## Patentansprüche

1. Organische Leuchtdiodenanzeige (101), umfassend:
einen Substrathauptkörper (111);
eine Anordnung von organischen Leuchtdioden (70), die jeweils eine erste Elektrode (710), eine organische Leuchtschicht (Substrathauptkörper (111) angeordnet sind; 720) und eine zweite Elektrode (730) umfassen, die der Reihe nach auf dem
eine Selektivreflexionsschicht (580), die auf den organischen Leuchtdioden (70) angeordnet ist;
eine Phasenverzögerungsdünnschicht (570), die auf der Selektivreflexionsschicht (580) angeordnet ist;
eine erste linear polarisierende Dünnschicht (560), die auf der Phasenverzögerungsdünnschicht (570) angeordnet ist;
**gekennzeichnet durch**:
eine verdrillt nematische Flüssigkristallschicht (550), die auf der ersten linear polarisierenden Dünnschicht (560) angeordnet ist;
eine Flüssigkristallansteuerungselektrode (230), die auf der verdrillt nematischen Flüssigkristallschicht (550) angeordnet ist; und
eine zweite linear polarisierende Dünnschicht (510), die auf der Flüssigkristallansteuerungselektrode (230) angeordnet ist.

2. Organische Leuchtdiodenanzeige (101) nach Anspruch 1, wobei die Anzeige dafür eingerichtet ist, ein elektrisches Feld zwischen der zweiten Elektrode (730) irgendeiner der organischen Leuchtdioden (70) und der Flüssigkristallansteuerungselektrode (230) anzulegen, wenn die jeweilige organische Leuchtdiode (70) Licht emittiert, und kein elektrisches Feld zwischen der zweiten Elektrode (730) irgendeiner der organischen Leuchtdioden (70) und der Flüssigkristallansteuerungselektrode (230) anzulegen, wenn die jeweilige organische Leuchtdiode (70) Licht kein emittiert.

3. Organische Leuchtdiodenanzeige (101) nach Anspruch 2, wobei, wenn ein elektrisches Feld zwischen der zweiten Elektrode (730) einer jeweiligen der organischen Leuchtdioden (70) und der Flüssigkristallansteuerungselektrode (230) angelegt wird, Flüssigkristallmoleküle (555) innerhalb der verdrillt nematischen Flüssigkristallschicht (550) im wesentlichen in einer Richtung ausgerichtet werden, die sich zwischen der Vorderseite und der Hinterseite der Anzeige (101) erstreckt.

4. Organische Leuchtdiodenanzeige (101) nach Anspruch 3, wobei die verdrillt nematische Flüssigkristallschicht (550) und die erste linear polarisierende Dünnschicht (560) dafür eingerichtet sind, äußeres Licht transparent durchzulassen, das durch Durchlaufen der zweiten linear polarisierenden Dünnschicht (510) linear polarisiert worden ist.

5. Organische Leuchtdiodenanzeige (101) nach Anspruch 3 oder 4, wobei die verdrillt nematische Flüssigkristallschicht (550) und die zweite linear polarisierende Dünnschicht (510) dafür eingerichtet sind, Licht transparent durchzulassen, das durch eine jeweilige organische Leuchtdiode (70) erzeugt und durch Durchlaufen der ersten linear polarisierenden Dünnschicht (560) linear polarisiert wurde.

6. Organische Leuchtdiodenanzeige (101) nach einem der Ansprüche 2 bis 5, wobei, wenn kein elektrisches Feld zwischen der zweiten Elektrode (730) einer jeweiligen der organischen Leuchtdioden (70) und der Flüssigkristallansteuerungselektrode (230) angelegt wird, Flüssigkristallmoleküle (555) innerhalb der verdrillt nematischen Flüssigkristallschicht (550) im wesentlichen in einer Richtung ausgerichtet werden, die sich quer über die Anzeige (101) erstreckt, wobei sie um 90 Grad verdrillt werden.

7. Organische Leuchtdiodenanzeige (101) nach Anspruch 6, wobei, wenn kein elektrisches Feld zwischen der zweiten Elektrode (730) einer jeweiligen der organischen Leuchtdioden (70) und der Flüssigkristallansteuerungselektrode (230) angelegt wird, Flüssigkristallmoleküle (555), die am nächsten zur Flüssigkristallansteuerungselektrode (230) angeordnet sind, und Flüssigkristallmoleküle (555), die am nächsten zur ersten linear polarisierenden Dünnschicht (560) angeordnet sind, in Bezug aufeinander um 90 Grad verdrillt sind.

8. Organische Leuchtdiodenanzeige (101) nach Anspruch 7, wobei, wenn kein elektrisches Feld zwischen der zweiten Elektrode (730) einer jeweiligen der organischen Leuchtdioden (70) und der Flüssigkristallansteuezungselektrode (230) angelegt wird, die Ausrichtung der Flüssigkristallmoleküle (555), die am nächsten zur Flüssigkristallansteuerungselektrode (230) angeordnet sind, mit der Richtung der Polarisationsachse der zweiten linear polarisierenden Dünnschicht (510) zusammenfällt.

9. Organische Leuchtdiodenanzeige (101) nach Anspruch 7 oder 8, wobei, wenn kein elektrisches Feld zwischen der zweiten Elektrode (730) einer jeweiligen der organischen Leuchtdioden (70) und der Flüssigkristallansteuerungselektrode (230) angelegt wird, die Ausrichtung der Flüssigkristallmoleküle (555), die am nächsten zur ersten linear polarisierenden Dünnschicht (560) angeordnet sind, mit einer Richtung der Polarisationsachse der ersten linear polarisierenden Dünnschicht (560) einen Winkel von 90 Grad bilden.

10. Organische Leuchtdiodenanzeige (101) nach Anspruch 7, 8 oder 9, wobei, wenn kein elektrisches Feld zwischen der ersten Elektrode (710) einer jeweiligen der organischen Leuchtdioden (70) und der Flüssigkristallansteuerungselektrode (230) angelegt wird, die Richtung der Achse der Polarisation äußeren Lichts, das die verdrillt nematische Flüssigkristallschicht (550) durchläuft, eine Richtung der Polarisationsachse der ersten linear polarisierenden Dünnschicht (560) schneidet.

11. Organische Leuchtdiodenanzeige (101) nach einem der vorhergehenden Ansprüche, wobei die Richtung der Polarisationsachse der ersten linear polarisierenden Dünnschicht (560) mit der Richtung der Polarisationsachse der zweiten linear polarisierenden Dünnschicht (510) zusammenfällt.

12. Organische Leuchtdiodenanzeige (101) nach einem der vorhergehenden Ansprüche, wobei die Selektivreflexionsschicht (580) eine cholesterische Flüssigkristallschicht, CLC, ist.

13. Organische Leuchtdiodenanzeige (101) nach Anspruch 12, wobei die Selektivreflexionsschicht (580) dafür eingerichtet ist, entweder links zirkular polarisiertes Licht oder rechts zirkular polarisiertes Licht durchzulassen, während sie das andere reflektiert.

14. Organische Leuchtdiodenanzeige (101) nach einem der vorhergehenden Ansprüche, wobei die Phasenverzögerungsdünnschicht (570) dafür eingerichtet ist, äußeres Licht zirkular zu polarisieren, das durch Durchlaufen der ersten linear polarisierenden Dünnschicht (560) linear polarisiert worden ist.

15. Organische Leuchtdiodenanzeige (101) nach einem der vorhergehenden Ansprüche, wobei die Selektivreflexionsschicht (580) dafür eingerichtet ist, zirkular polarisiertes Licht transparent durchzulassen, das die Phasenverzögerungsdünnschicht (570) durchlaufen hat.

16. Organische Leuchtdiodenanzeige (101) nach einem der vorhergehenden Ansprüche, wobei die Phasenverzögerungsdünnschicht (570) eine Viertelwellenlängendünnschicht ist und die Polarisationsachse der Phasenverzögerungsdünnschicht (570) mit der Polarisationsachse der ersten linear polarisierenden Dünnschicht (560) einen Winkel von 45 Grad bildet.

17. Organische Leuchtdiodenanzeige (101) nach einem der vorhergehenden Ansprüche, dafür eingerichtet, zu bewirken, dass Licht, das durch die organischen Leuchtdioden (70) erzeugt und durch Durchlaufen der Selektivreflexionsschicht (580) zirkular polarisiert wurde, bei Durchlaufen der Phasenverzögerungsdünnschicht (570) in einer gleichen Richtung wie der Richtung der Polarisationsachse der ersten linear polarisierenden Dünnschicht (560) linear polarisiert wird.

18. Organische Leuchtdiodenanzeige (101) nach einem der vorhergehenden Ansprüche, wobei die organischen Leuchtdioden (70) Licht in einer Richtung des verdrillt nematischen Flüssigkristalls (550) emittieren.

## Revendications

1. Afficheur à diodes électroluminescentes organiques (101), comprenant :
un corps principal de substrat (111);
un ensemble de diodes électroluminescentes organiques (70) comprenant chacune une première électrode (710), une couche d'émission de lumière organique (720), et une deuxième électrode (730) agencées séquentiellement sur le corps principal de substrat (111);
une couche de réflexion sélective (580) agencée sur les diodes électroluminescentes organiques (70) ;
un film de retardement de phase (570) agencé sur la couche de réflexion sélective (580) ;
un premier film de polarisation linéaire (560) agencé sur le film de retardement de phase (570) ;
**caractérisé par**
une couche de cristaux liquides nématiques en hélice (550) agencée sur le premier film de polarisation linéaire (560) ;
une électrode de commande de cristaux liquides (230) agencée sur la couche de cristaux liquides nématiques en hélice (550) ; et
un deuxième film de polarisation linéaire (510) agencé sur l'électrode de commande de cristaux liquides (230).

2. Afficheur à diodes électroluminescentes organiques (101) selon la revendication 1, dans lequel l'afficheur est conçu pour appliquer un champ électrique entre la deuxième électrode (730) de l'une quelconque des diodes électroluminescentes organiques (70) et l'électrode de commande de cristaux liquides (230) lorsque la diode électroluminescente organique (70) respective émet de la lumière, et ne pas appliquer un champ électrique entre la deuxième électrode (730) de l'une quelconque des diodes électroluminescentes organiques (70) et l'électrode de commande de cristaux liquides (230) lorsque la diode électroluminescente organique (70) respective n'émet pas de lumière.

3. Afficheur à diodes électroluminescentes organiques (101) selon la revendication 2, dans lequel, lorsqu'un champ électrique est appliqué entre la deuxième électrode (730) d'une diode respective parmi les diodes électroluminescentes organiques (70) et l'électrode de commande de cristaux liquides (230), les molécules de cristaux liquides (555) dans la couche de cristaux liquides nématiques en hélice (550) sont sensiblement orientées dans une direction s'étendant entre l'avant et l'arrière de l'afficheur (101).

4. Afficheur à diodes électroluminescentes organiques (101) selon la revendication 3, dans lequel la couche de cristaux liquides nématiques en hélice (550) et le premier film de polarisation linéaire (560) sont conçus pour laisser passer de manière transparente la lumière externe qui a été polarisée linéairement en passant à travers le deuxième film de polarisation linéaire (510).

5. Afficheur à diodes électroluminescentes organiques (101) selon la revendication 3 ou 4, dans lequel la couche de cristaux liquides nématiques en hélice (550) et le deuxième film de polarisation linéaire (510) sont conçus pour laisser passer de manière transparente la lumière produite par une diode électroluminescente organique (70) respective et polarisée linéairement en passant à travers le premier film de polarisation linéaire (560).

6. Afficheur à diodes électroluminescentes organiques (101) selon l'une quelconque des revendications 2 à 5, dans lequel, lorsque aucun champ électrique n'est appliqué entre la deuxième électrode (730) d'une diode respective parmi les diodes électroluminescentes organiques (70) et l'électrode de commande de cristaux liquides (230), les molécules de cristaux liquides (555) dans la couche de cristaux liquides nématiques en hélice (550) sont sensiblement orientées dans une direction s'étendant en travers de l'afficheur (101) tout en étant tournées de 90 degrés.

7. Afficheur à diodes électroluminescentes organiques (101) selon la revendication 6, dans lequel, lorsque aucun champ électrique n'est appliqué entre la deuxième électrode (730) d'une diode respective parmi les diodes électroluminescentes organiques (70) et l'électrode de commande de cristaux liquides (230), les molécules de cristaux liquides (555) agencées le plus près de l'électrode de commande de cristaux liquides (230) et les molécules de cristaux liquides (555) agencées le plus près du premier film de polarisation linéaire (560) sont tournées de 90 degrés les unes par rapport aux autres.

8. Afficheur à diodes électroluminescentes organiques (101) selon la revendication 7, dans lequel, lorsque aucun champ électrique n'est appliqué entre la deuxième électrode (730) d'une diode respective parmi les diodes électroluminescentes organiques (70) et l'électrode de commande de cristaux liquides (230), la direction d'orientation des molécules de cristaux liquides (555) agencées le plus près de l'électrode de commande de cristaux liquides (230) coïncide avec la direction de l'axe de polarisation du deuxième film de polarisation linéaire (510).

9. Afficheur à diodes électroluminescentes organiques (101) selon la revendication 7 ou 8, dans lequel, lorsque aucun champ électrique n'est appliqué entre la deuxième électrode (730) d'une diode respective parmi les diodes électroluminescentes organiques (70) et l'électrode de commande de cristaux liquides (230), la direction d'orientation des molécules de cristaux liquides (555) agencées le plus près du premier film de polarisation linéaire (560) forme un angle de 90 degrés avec une direction de l'axe de polarisation du premier film de polarisation linéaire (560).

10. Afficheur à diodes électroluminescentes organiques (101) selon la revendication 7, 8 ou 9, dans lequel, lorsque aucun champ électrique n'est appliqué entre la première électrode (710) d'une diode respective parmi les diodes électroluminescentes organiques (70) et l'électrode de commande de cristaux liquides (230), la direction de l'axe de polarisation de la lumière externe passant à travers la couche de cristaux liquides nématiques en hélice (550) croise une direction de l'axe de polarisation du premier film de polarisation linéaire (560).

11. Afficheur à diodes électroluminescentes organiques (101) selon l'une quelconque des revendications précédentes, dans lequel la direction de l'axe de polarisation du premier film de polarisation linéaire (560) coïncide avec la direction de l'axe de polarisation du deuxième film de polarisation linéaire (510).

12. Afficheur à diodes électroluminescentes organiques (101) selon l'une quelconque des revendications précédentes, dans lequel la couche de réflexion sélective (580) est une couche de cristaux liquides cholestériques, CLC.

13. Afficheur à diodes électroluminescentes organiques (101) selon la revendication 12, dans lequel la couche de réflexion sélective (580) est conçue pour laisser passer l'une de la lumière polarisée circulairement vers la gauche et de la lumière polarisée circulairement vers la droite tout en réfléchissant l'autre.

14. Afficheur à diodes électroluminescentes organiques (101) selon l'une quelconque des revendications précédentes, dans lequel le film de retardement de phase (570) est conçu pour polariser circulairement la lumière externe qui a été polarisée linéairement en passant à travers le premier film de polarisation linéaire (560).

15. Afficheur à diodes électroluminescentes organiques (101) selon l'une quelconque des revendications précédentes, dans lequel la couche de réflexion sélective (580) est conçue pour laisser passer de manière transparente la lumière polarisée circulairement qui est passée à travers le film de retardement de phase (570).

16. Afficheur à diodes électroluminescentes organiques (101) selon l'une quelconque des revendications précédentes, dans lequel le film de retardement de phase (570) est un film quart d'onde, et l'axe de polarisation du film de retardement de phase (570) forme un angle de 45 degrés par rapport à l'axe de polarisation du premier film de polarisation linéaire (560).

17. Afficheur à diodes électroluminescentes organiques (101) selon l'une quelconque des revendications précédentes, conçu pour amener la lumière produite par la diode électroluminescente organique (70) et polarisée circulairement en passant à travers la couche de réflexion sélective (580) à être polarisée linéairement dans une direction identique à la direction de l'axe de polarisation du premier film de polarisation linéaire (560) lors de son passage à travers le film de retardement de phase (570).

18. Afficheur à diodes électroluminescentes organiques (101) selon l'une quelconque des revendications précédentes, dans lequel les diodes électroluminescentes organiques (70) émettent de la lumière dans une direction de la couche de cristaux liquides nématiques en hélice (550).
